(19) Europäisches Patentamt
European Patent Office
Office européen des brevets

(11) **EP 1 748 496 B1**

(12) **EUROPÄISCHE PATENTSCHRIFT**

(45) Veröffentlichungstag und Bekanntmachung des Hinweises auf die Patenterteilung:
**24.04.2019 Patentblatt 2019/17**

(51) Int Cl.:
*H01L 33/14* *(2010.01)*  *H01L 33/04* *(2010.01)*
*H01L 33/12* *(2010.01)*  *H01L 33/02* *(2010.01)*
*H01L 33/32* *(2010.01)*  *H01S 5/323* *(2006.01)*

(21) Anmeldenummer: **06014455.7**

(22) Anmeldetag: **12.07.2006**

(54) **Strahlungsemittierender Halbleiterchip**

Light emitting semiconductor chip

Puce semi-conductrice électroluminescente

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **29.07.2005 DE 102005035721**
**07.10.2005 DE 102005048196**

(43) Veröffentlichungstag der Anmeldung:
**31.01.2007 Patentblatt 2007/05**

(73) Patentinhaber: **OSRAM Opto Semiconductors GmbH**
**93055 Regensburg (DE)**

(72) Erfinder:
• **Peter, Matthias**
**93087 Alteglofsheim (DE)**
• **Strauß, Uwe**
**93077 Bad Abbach (DE)**
• **Sabathil, Matthias**
**93059 Regensburg (DE)**

(74) Vertreter: **Epping - Hermann - Fischer Patentanwaltsgesellschaft mbH Schloßschmidstraße 5 80639 München (DE)**

(56) Entgegenhaltungen:
EP-A1- 1 453 160    WO-A1-2007/004768
GB-A- 2 352 326    JP-A- H06 209 139
US-A- 5 889 295    US-A- 5 889 806
US-A1- 2003 001 170    US-A1- 2004 101 012

• **KIM T G ET AL: "Structure optimization of InGaN-GaN ultraviolet light-emitting diode with a low-energy electron injection mechanism", JOURNAL OF CRYSTAL GROWTH, ELSEVIER, AMSTERDAM, NL, Bd. 272, Nr. 1-4, 10. Dezember 2004 (2004-12-10), Seiten 264-269, XP004658481, ISSN: 0022-0248, DOI: DOI:10.1016/J.JCRYSGRO.2004.08.100**

**Beschreibung**

Die vorliegende Erfindung betrifft einen strahlungsemittierenden Halbleiterchip mit einem zur Strahlungserzeugung geeigneten aktiven Bereich.

In der Druckschrift US 2003/0001170 A1 ist ein strahlungsemittierendes Halbleiterbauelement mit einer Vielfach-Quantentopf-Schicht in einem aktiven Bereich beschrieben. In Druckschrift US 5,889,295 A wird vorgeschlagen, zur Reduzierung von Kristalldefekten GaN-Schichten durch eine ZnO/GaN-Übergitterstruktur und/oder InGaN-Schichten durch eine ZnO/InN-Übergitterstruktur zu ersetzen, wobei diese Ersetzung in der Regel zu einer Verschiebung der Leitungs- sowie Valenzbandkante an Grenzschichten führt. Druckschrift JP H06 209139 A beschreibt einen Halbleiterlaser mit einer Barriereschicht, wobei die Barriereschicht bevorzugt als Tunnel-Barriereschicht für Elektronen oder Löcher ausgebildet ist und wobei es wünschenswert ist, die Barriereschicht durch ein sogenanntes gestaffeltes Hetero-Junction-System als Löcher-Barriereschicht auszubilden, die keine Potenzialbarriere für Elektronen aufweist. Druckschrift US 5,889,806 A beschreibt eine Laserdiode gemäß dem Oberbegriff des Anspruchs 1, unter anderem mit einem aktiven Bereich, einer n-seitigen Stoppschicht, einer Wellenleiterschicht und einer Mantelschicht, wobei die Stoppschicht als Barriereschicht ausgeführt ist. Die Mantelschicht, die Wellenleiterschicht und die Stoppschicht weisen bevorzugt die gleiche Dotierung, insbesondere die gleichen Si-Konzentrationen auf.

Die interne Quanteneffizienz von Halbleiterchips bei der Strahlungserzeugung, insbesondere solchen, die auf Nitrid-Verbindungshalbleitermaterialen basieren, hängt oftmals maßgeblich von der Betriebsstromdichte ab, mit der der Halbleiterchip betrieben wird. Unter interner Quanteneffizienz wird hierbei das Verhältnis der Anzahl an in den aktiven Bereich injizierter Ladungsträger eines Typs - Elektronen oder Löcher - zur Anzahl der hieraus im aktiven Bereich erzeugten Photonen verstanden.

Je größer die Betriebsstromdichte, desto geringer ist oftmals, insbesondere bei Halbleiterchips auf Nitrid-Basis, die interne Quanteneffizienz. Ein effizienterer Betrieb von Halbleiterchips bei hohen Stromdichten würde es erleichtern, kostengünstig, ohne Vergrößerung der aktiven Fläche, das heißt der Fläche des aktiven Bereichs des Chips, mit diesem Halbleiterchip eine erhöhte Strahlungsleistung zu erzeugen.

Eine Aufgabe der vorliegenden Erfindung ist es, einen Halbleiterchip anzugeben der vereinfacht mit einer verringerten Abhängigkeit der internen Quanteneffizienz von der Betriebsstromdichte ausbildbar ist.

Diese Aufgabe wird erfindungsgemäß durch einen Halbleiterchip mit den Merkmalen des Patentanspruchs 1 gelöst. Vorteilhafte Weiterbildungen und Ausgestaltungen der Erfindung sind Gegenstand der abhängigen Patentansprüche.

Die vorliegende Erfindung ist somit in Anspruch 1 definiert. Ausführungsbeispiele und Ausgestaltungen der vorliegenden Erfindung sind im Folgenden nur solche Beispiele, die alle Merkmale des durch Anspruch 1 definierten Gegenstands enthalten.

Ein erfindungsgemäßer strahlungsemittierender Halbleiterchip umfasst einen Halbleiterkörper, der einen n-leitenden Bereich und einen p-leitenden Bereich aufweist, wobei zwischen dem n-leitenden Bereich und dem p-leitenden Bereich ein zur Strahlungserzeugung geeigneter aktiver Bereich angeordnet ist, in dem über den n-leitenden Bereich in den aktiven Bereich geführte Elektronen und über den p-leitenden Bereich in den aktiven Bereich geführte Löcher unter Strahlungserzeugung rekombinieren. Auf der dem p-leitenden Bereich gegenüberliegenden Seite des aktiven Bereichs des erfindungsgemäßen Halbleiterchips ist eine Löcher-Barriereschicht angeordnet, die ein Material aus dem III-V-Halbleitermaterialsystem $In_yGa_{1-x-y}Al_xN$ mit $0 \leq x \leq 1$, $0 \leq y \leq 1$ und $x + y \leq 1$ enthält und für die Elektronen durchlässig ist. Die Löcher-Barriereschicht ist hierbei bevorzugt derart im Halbleiterkörper angeordnet und derart ausgebildet, dass sie ein Eindringen von Löchern in den n-leitenden Bereich mindert oder vollständig blockiert.

Die Löcher-Barriereschicht behindert also das Eindringen von Löchern in den n-leitenden Bereich und vermindert somit die Wahrscheinlichkeit, dass Löcher im n-leitenden Bereich mit Elektronen nicht-strahlend rekombinieren. Die Wahrscheinlichkeit das Löcher im aktiven Bereich strahlend rekombinieren wird dementsprechend erhöht, da die Löcher mittels der Löcher-Barriereschicht vermehrt auf der dem aktiven Bereich zugewandten Seite der Löcher-Barriereschicht gehalten werden. Insbesondere können Löcher auf diese Weise auch für hohe Stromdichten vermehrt auf der dem aktiven Bereich zugewandten Seite der Löcher-Barriereschicht gehalten werden. Die interne Quanteneffizienz kann mittels der Löcher-Barriereschicht demnach vorteilhaft erhöht werden. Die Abhängigkeit der internen Quanteneffizienz von der Betriebsstromdichte wird mittels der Löcher-Barriereschicht mit Vorteil verringert. Dies äußert sich bei vergleichsweise hohen Stromdichten in besonderem Maße, da die Eintrittswahrscheinlichkeit von Löchern in den n-leitenden Bereichen mit wachsender Betriebsstromdichte in der Regel stark und nichtlinear zunimmt.

Die Löcher-Barriereschicht ist bevorzugt derart ausgebildet, dass die Durchtrittswahrscheinlichkeit von Elektronen durch die Löcher-Barriereschicht größer ist als die Durchtrittswahrscheinlichkeit der Löcher durch die Löcher-Barriereschicht. Eine Barriere für den Durchtritt von Elektronen durch die Löcher-Barriereschicht ist hierzu vorzugsweise kleiner als eine Barriere für den Durchtritt von Löchern durch die Löcher-Barriereschicht.

Dies kann durch geeignete Ausbildung der Löcher-Barriereschicht erreicht werden. Beispielsweise wird mittels der Löcher-Barriereschicht eine Potenzial-Barriere für die Löcher gebildet. Je höher diese Potenzial-Barriere ist, desto geringer ist in der Regel die Durchtrittswahrscheinlichkeit der Löcher. Weiterhin verringert sich die Durchtrittswahrscheinlichkeit in der Regel auch mit wachsender Dicke der Löcher-Barriereschicht. Die Potenzial-Barriere kann mittels einer Bandlücke der Löcher-Barriereschicht eingestellt werden. Gegebenenfalls kann die Potenzial-Barriere für die Löcher durch geeignete Dotierung, insbesondere durch geeignete n-leitende Dotierung, erhöht werden, wobei besonders bevorzugt die Potenzial-Barriere für Elektronen zugleich vermindert wird.

Das Verhältnis der Durchtrittswahrscheinlichkeit der Elektronen durch die Löcher-Barriereschicht zu derjenigen der Löcher kann beispielsweise 1/10 oder weniger, bevorzugt 1/100 oder weniger, besonders bevorzugt 1/1000 oder weniger betragen. Je kleiner dieses Verhältnis ist, desto geringer ist die Gefahr, dass die Löcher-Barriereschicht durch Blockade der Elektronen die interne Quanteneffizienz aufgrund der dann verringerten, zum aktiven Bereich gelangenden Anzahl von Elektronen vermindert.

Bevorzugt ist die Löcher-Barriereschicht zwischen dem n-leitenden Bereich und dem aktiven Bereich angeordnet. Das Eindringen von Löchern in den n-leitenden Bereich kann mittels einer derartigen Anordnung besonders effektiv vermindert werden. Die Löcher-Barriereschicht kann intrinsisch, das heißt undotiert, ausgeführt sein. Eine nichtdotierte Schicht kann gegenüber einer dotierten Schicht gegebenenfalls vereinfacht gefertigt sein. Alternativ kann die Löcher-Barriereschicht jedoch auch dotiert, insbesondere n-leitend dotiert, ausgeführt sein. Zweckmäßigerweise ist die Löcher-Barriereschicht dann im n-leitenden Bereich integriert.

Eine Anordnung der Löcher-Barriereschicht auf einer dem aktiven Bereich zugewandten Seite des n-leitenden Bereichs im n-leitenden Bereich ist für eine Löcherbarriere ferner besonders zweckmäßig. Bevorzugt ist der n-leitende Bereich durch die Löcher-Barriereschicht seitens des aktiven Bereichs begrenzt.

Weiterhin grenzt die Löcher-Barriereschicht bevorzugt an den aktiven Bereich an oder die Löcher-Barriereschicht begrenzt den aktiven Bereich. Im letzteren Fall kann die Löcher-Barriereschicht beispielsweise zugleich als Einschlussschicht für den aktiven Bereich dienen, mittels derer Ladungsträger im aktiven Bereich eingeschlossen werden können (Confinement). Eine Anordnung der Löcher-Barriereschicht möglichst nahe am aktiven Bereich ist für eine Löcher-Barriereschicht besonders vorteilhaft.

Gemäß einer Ausführungsform der vorliegenden Erfindung ist der Aluminiumgehalt x in der Löcher-Barriereschicht größer 0. Mittels des Aluminiumgehalts kann die Bandlücke der Löcher-Barriereschicht eingestellt und hierüber die Höhe der resultierenden Potenzial-Barriere für die Löcher bestimmt werden. Je größer der Aluminiumgehalt ist, desto größer ist in der Regel die Bandlücke der Löcher-Barriereschicht. Mit der Bandlücke wächst in der Regel auch die Barrierenhöhe.

Gemäß einer Ausführungsform der vorliegenden Erfindung ist der Aluminiumgehalt x größer oder gleich 0,2, besonders bevorzugt größer oder gleich 0,5, zum Beispiel bis 1. Mit derartigen Aluminiumgehalten kann eine effiziente Löcherblockade mittels der Löcher-Barriereschicht, insbesondere in einem auf Nitrid-Verbindungshalbleitern basierenden Halbleiterkörper, erreicht werden.

Mit wachsendem Aluminiumgehalt verringert sich jedoch in der Regel auch die Gitterkonstante der Löcher-Barriereschicht. Insbesondere gilt dies für eine indiumfreie Löcher-Barriereschicht mit y = 0. Hieraus können tensile Verspannungen im Halbleiterkörper resultieren. Derartige Verspannungen im Halbleiterkörper, insbesondere im aktiven Bereich, können wiederum zu einer Verringerung der internen Quanteneffizienz des Halbleiterchips führen. Insbesondere gilt dies für einen aktiven Bereich, der eine Schicht aus dem III-V-Halbleitermaterialsystem $In_yGa_{1-y}N$ mit $0 < y \leq 1$ enthält oder auf diesem Materialsystem basiert. Eine Schicht aus diesem Materialsystem ist aluminiumfrei. Die Gitterfehlanpassung einer derartigen Schicht zu einer aluminiumhaltigen Schicht kann daher in erhöhtem Maße zu Verspannungen im Halbleiterkörper, insbesondere dem aktiven Bereich, führen. Um die aufgrund der Löcher-Barriereschicht im Halbleiterkörper resultierende Verspannung tolerabel gering zu halten, ist x bevorzugt kleiner oder gleich 0,45. Von besonderer Bedeutung ist dies, falls die Löcher-Barriereschicht indiumfrei mit y = 0 ausgebildet ist.

Ist die Löcher-Barriereschicht indiumhaltig, das heißt mit y größer 0, ausgebildet, so können mit Vorteil die Gitterkonstante und die Bandlücke der Löcher-Barriereschicht über Variation des Indiumgehalts y und des Aluminiumgehalts x im wesentlichen unabhängig voneinander eingestellt werden. Die Löcher-Barriereschicht kann somit als Pufferschicht ausgebildet sein. Über die Pufferschicht kann beim Herstellen des Halbleiterkörpers, beispielsweise mittels epitaktischen Aufwachsens, die Gitterkonstante für auf die Pufferschicht aufzubringende weitere Halbleiterschichten optimiert werden. Verspannungen können so reduziert werden. Bevorzugt ist die Löcher-Barriereschicht als Pufferschicht für die Schicht(en) für den aktiven Bereich ausgebildet. Einer Effizienzminderung des aktiven Bereichs, insbesondere eines aktiven Bereichs auf InGaN-Basis, kann so vorgebeugt werden. Gemäß der vorliegenden Anmeldung ist hierbei $0 < y < x \leq 1$. Der aufgrund des vergleichsweise hohen Aluminiumsgehalts x vereinfacht auftretenden tensilen Verspannung kann mit Vorteil mit einem gegenüber dem Aluminiumgehalt x geringeren Indiumgehalt y bereits ausreichend entgegengewirkt werden. Bevorzugt wird eine Verspannung vollständig vermieden. Eine indiumfreie, aluminiumhaltige Löcher-Barriereschicht ist jedoch gegenüber einer indium- und aluminiumhaltigen Löcher-Barriereschicht vereinfacht herstellbar.

In einer weiteren bevorzugten Ausgestaltung ist die Löcher-Barriereschicht als Tunnel-Barriereschicht ausgeführt, wobei die Tunnel-Barriereschicht derart ausgebildet ist, dass sie von den Elektronen mit höherer Wahrscheinlichkeit durchtunnelt wird, als von den Löchern. Mittels der Tunnel-Barriereschicht wird sowohl für die Elektronen, als auch für Löcher eine Potenzial-Barriere ausgebildet, wobei die jeweilige Potenzial-Barriere von Elektronen vor dem Eindringen in den aktiven Bereich und von Löchern vor dem Eindringen in den n-leitenden Bereich zu überwinden ist.

Die Energie der Leitungsbandkante der Tunnel-Barriereschicht ist bevorzugt größer als die Energie der Leitungsbandkante einer seitens des n-leitenden Bereichs an die Tunnel-Barriereschicht angrenzende Schicht. Die Differenz dieser Energien bestimmt die maximale Barrierenhöhe der von den Elektronen vor dem Eindringen in den aktiven Bereich zu überwindenden Potenzial-Barriere.

Die Energie der Valenzbandkante der Tunnel-Barriereschicht ist bevorzugt kleiner als die Energie der Valenzbandkante einer auf der dem n-leitenden Bereich gegenüber liegenden Seite der Tunnel-Barriereschicht angeordneten, insbesondere an die Tunnel-Barriereschicht angrenzenden Schicht, zum Beispiel einer Schicht des aktiven Bereichs. Die Differenz dieser Energien bestimmt die maximale Barrierenhöhe der von den Löchern vor dem Eindringen in den n-leitenden Bereich zu überwindenden Potenzial-Barriere.

Eine Bandlücke der Tunnel-Barriereschicht ist weiterhin bevorzugt größer als die Bandlücke einer seitens des n-leitenden Bereichs und/oder einer auf der dem n-leitenden Bereich gegenüberliegenden Seite im Halbleiterkörper an die Tunnel-Barriereschicht angrenzenden Schicht. Das Ausbilden einer Barriere für Elektronen und Löcher wird so erleichtert.

Die Tunnelwahrscheinlichkeit hängt von der Barrierenhöhe und der Barrierendicke ab. Je dicker die Tunnel-Barriereschicht beziehungsweise je höher die Potenzial-Barriere ist, desto geringer ist in der Regel die Tunnelwahrscheinlichkeit. Die Tunnelwahrscheinlichkeit wird weiterhin durch die effektive Masse der Ladungsträger bestimmt, wobei die Tunnelwahrscheinlichkeit in der Regel mit wachsender effektiver Masse abnimmt. Da die Löcher regelmäßig eine effektive Masse größer derjenigen der Elektronen aufweisen, ist die Tunnelwahrscheinlichkeit der Löcher häufig geringer als die der Elektronen.

Bevorzugt weist die Tunnel-Barriereschicht eine Dicke von 8 nm oder weniger, besonders bevorzugt von 4 nm oder weniger, auf. Weiterhin ist bevorzugt $0{,}2 \leq x \leq 0{,}45$. Mittels derartiger Tunnel-Barriereschichten kann eine Tunnelbarriere ausgebildet werden, die ein Eindringen von Löchern in den n-leitenden Bereich effizient mindert und das Durchtreten von Elektronen vom n-leitenden Bereich in den aktiven Bereich nur moderat behindert. Weiterhin kann eine Verspannung im Halbleiterkörper über eine Wahl des Aluminiumgehalts im oben angeführten Bereich vergleichsweise gering gehalten werden. Besonders bevorzugt ist der Aluminiumgehalt für eine Tunnelbarriereschicht größer oder gleich 0,3.

Die Tunnel-Barriereschicht kann n-leitend dotiert oder intrinsisch ausgeführt sein. Über n-leitende Dotierung, zum Beispiel mittels Si, kann die Barrierenhöhe für Elektronen abgesenkt werden. Aufgrund der bei der Dotierung im wesentlichen konstant bleibenden Bandlücke wird die Barriere für die Löcher hierüber zugleich erhöht. Eine undotierte Schicht ist gegenüber einer dotierten Schicht vereinfacht herstellbar. Weiterhin können Störstellen in die Tunnel-Barriereschicht eingebaut werden, die das Tunneln der Elektronen assistieren und die Tunnelwahrscheinlichkeit der Elektronen gegenüber der der Löcher erhöhen. Als Störstellenatom eignet sich beispielsweise Si.

Gemäß einer Ausführungsform der vorliegenden Erfindung ist die Löcher-Barriereschicht als reine Löcher-Barriereschicht ausgebildet, die ein Durchtreten von Löchern, insbesondere vollständig, blockiert. Bevorzugt ist die reine Löcher-Barriereschicht für die Elektronen im wesentlichen vollständig durchlässig. Die reine Löcher-Barriereschicht bildet weiterhin mit Vorzug eine Potenzial-Barriere für die Löcher aus, während, im Gegensatz zu einer Tunnel-Barriereschicht, die Elektronen im wesentlichen potenzialbarrierefrei durch die reine Löcher-Barriereschicht hindurchtreten. Aufgrund des ungehinderten Durchtritts der Elektronen durch die reine Löcherbarriereschicht kann verglichen mit einer Tunnel-Barriereschicht die interne Quanteneffizienz des Halbleiterchips erhöht sein.

Bevorzugt ist die reine Löcher-Barriereschicht derart n-leitend dotiert, dass die Energie der Leitungsbandkante der Löcher-Barriereschicht kleiner oder gleich der Energie der Leitungsbandkante einer auf der dem aktiven Bereich gegenüberliegenden Seite der reinen Löcher-Barriereschicht an die reine Löcher-Barriereschicht angrenzenden Schicht ist. Als Donator ist beispielsweise Si geeignet.

Die reine Löcher-Barriereschicht kann insbesondere eine derart hohe Potenzial-Barriere und/oder Dicke aufweisen, dass Elektronen, falls mittels der Löcher-Barriereschicht auch eine Elektronen-Barriere gebildet wäre, diese nicht oder nur mit einer Wahrscheinlichkeit von $10^{-5}$ oder weniger durchdringen würden. Für eine vollständig durchlässige Schicht wäre die Durchtrittswahrscheinlichkeit gleich 1.

Bevorzugt weist die reine Löcher-Barriereschicht eine Dicke von 11 nm oder mehr auf. Weiterhin weist die reine Löcher-Barriereschicht bevorzugt eine Dicke von 30 nm oder weniger auf. Eine reine Löcher-Barriereschicht einer derartigen Dicke hat sich zur effizienten Blockade des Eindringens von Löchern in den n-leitenden Bereich als besonders geeignet erwiesen. Die Löcher-Barriereschicht kann natürlich auch mit einer Dicke von mehr als 30 nm ausgeführt sein, wobei die Barrierewirkung durch Vergrößerung dieser Dicke nicht maßgeblich verstärkt wird.

Ferner hat sich ein Aluminiumgehalt mit $0{,}2 \leq x \leq 0{,}3$ für eine reine Löcher-Barriereschicht als besonders zweckmäßig erwiesen.

In einer weiteren bevorzugten Ausgestaltung ist der Halbleiterkörper auf einem Träger angeordnet. Der Halbleiterchip umfasst dann den Träger mit dem auf diesem angeordneten Halbleiterkörper. Der Träger kann den Halbleiterkörper, der vorzugsweise eine Halbleiterschichtenfolge mit einer Mehrzahl von Halbleiterschichten aufweist, mechanisch stabilisieren.

Beispielsweise kann der Träger aus einem Epitaxiesubstrat, auf dem der Halbleiterkörper epitaktisch gewachsen ist, gebildet sein. Der Träger kann jedoch auch von dem Epitaxiesubstrat verschieden sein. Ist der Träger vom Epitaxiesubstrat verschieden, so wird der Halbleiterchip auch als Dünnfilm-Chip bezeichnet. Für Dünnfilm-Chips wird der Halbleiterkörper bevorzugt zunächst auf dem Epitaxiesubstrat gewachsen. Nachfolgend wird der Halbleiterkörper, bevorzugt auf der dem Epitaxiesubstrat abgewandten Seite, auf dem Träger angeordnet und vorzugsweise befestigt. Daraufhin wird das Epitaxiesubstrat, beispielsweise über Ätzen oder ein Lasertrennverfahren, abgelöst. Eine mechanische Unterstützung des Halbleiterkörpers wird durch den Träger gewährleistet.

Bei Dünnfilm-Chips ist die Löcher-Barriereschicht bevorzugt auf der dem Träger gegenüberliegenden Seite des aktiven Bereichs angeordnet, während die Löcher-Barriereschicht bei Nicht-Dünnfilm-Chips bevorzugt zwischen dem aktiven Bereich und dem Träger angeordnet ist. Eine derartige Anordnung ergibt sich insbesondere dann, wenn zuerst der n-leitende Bereich des Halbleiterkörpers auf dem Epitaxiesubstrat gewachsen wird. Der p-leitende Bereich ist dann auf der dem Epitaxiesubstrat abgewandten Seite des aktiven Bereichs angeordnet und wird bei der Ausbildung eines Dünnfilm-Chips demgemäß auf der Seite des Trägers angeordnet, sodass der aktive Bereich zwischen der Löcher-Barriereschicht und dem Träger angeordnet ist.

Für Dünnfilm-Chips kann der Träger gegenüber einem Epitaxiesubstrat vergleichsweise frei gewählt werden, da die Anforderungen an einen Träger für einen Dünnfilm-Chip in der Regel geringer sind als diejenigen, denen ein Epitaxiesubstrat, etwa hinsichtlich dessen Kristallstruktur, unterliegt. Der Träger kann beispielsweise hinsichtlich optimierter Wärme- und/oder elektrischer Leitfähigkeit gewählt werden.

Ein Dünnfilm-Chip, insbesondere ein Dünnfilm-Leuchtdioden-Chip, kann sich weiterhin durch mindestens eines der folgenden charakteristischen Merkmale auszeichnen:

- an einer zu dem Träger hin gewandten Hauptfläche des Halbleiterkörpers, der bevorzugt eine Epitaxieschichtenfolge aufweist, ist eine reflektierende Schicht aufgebracht oder ausgebildet, die zumindest einen Teil der im Halbleiterkörper erzeugten elektromagnetischen Strahlung in diesen zurückreflektiert,
- der Halbleiterkörper, insbesondere die Epitaxieschichtenfolge, weist eine Dicke im Bereich von $20\,\mu\mathrm{m}$ oder weniger, insbesondere im Bereich von $10\,\mu\mathrm{m}$ auf, und/oder
- der Halbleiterkörper, insbesondere die Epitaxieschichtenfolge, enthält mindestens eine Halbleiterschicht mit zumindest einer Fläche, die eine Durchmischungsstruktur aufweist, die im Idealfall zu einer annähernd ergodischen Verteilung des Lichtes im Halbleiterkörper, insbesondere in der Epitaxieschichtenfolge, führt, d.h. die Durchmischungsstruktur weist ein möglichst ergodisch stochastisches Streuverhalten auf.

Ein Grundprinzip eines Dünnschicht-Leuchtdiodenchips ist beispielsweise in I. Schnitzer et al., Appl. Phys. Lett. 63 (16), 18. Oktober 1993, 2174 - 2176 beschrieben.

Bevorzugt ist zwischen dem Träger und dem aktiven Bereich, besonders bevorzugt zwischen dem Halbleiterkörper und dem Träger, eine Spiegelschicht angeordnet. Die Spiegelschicht kann im aktiven Bereich erzeugte Strahlung reflektieren und somit eine Absorption von Strahlung in auf der dem aktiven Bereich gegenüberliegenden Seite der Spiegelschicht angeordneten Strukturen, wie etwa dem Träger, vermindern. Besonders bevorzugt ist die Spiegelschicht als metallische Spiegelschicht ausgeführt. Eine metallhaltige Spiegelschicht zeichnet sich durch eine Reflektivität aus, die in der Regel eine vorteilhaft geringe Richtungsabhängigkeit aufweist. Weiterhin ist die Spiegelschicht bevorzugt elektrisch leitend ausgeführt und besonders bevorzugt elektrisch leitend mit dem aktiven Bereich verbunden. Die elektrische Kontaktierung des Chips kann somit über die Spiegelschicht und gegebenenfalls über einen elektrisch leitenden Träger erfolgen.

Weitere Merkmale, Vorteile und Zweckmäßigkeiten der Erfindung ergeben sich aus der folgenden Beschreibung der Ausführungsbeispiele in Verbindung mit den Figuren.

Figur 1 zeigt eine schematische Schnittansicht eines ersten Ausführungsbeispiels eines erfindungsgemäßen strahlungsemittierenden Halbleiterchips,

Figur 2 zeigt schematisch den Verlauf der Valenz- und der Leitungsbandkante für eine Tunnel-Barriereschicht,

Figur 3 zeigt ein Diagramm mit den Tunnelwahrscheinlichkeiten für Elektronen und Löcher,

Figur 4 zeigt Ergebnisse einer Simulationsrechnung für den Verlauf der Leitungs- und der Valenzbandkante für verschieden ausgebildete Löcher-Barriereschichten,

Figur 5 zeigt schematisch den Verlauf der Valenz- und der Leitungsbandkante für eine reine Löcher-Barriereschicht, Figur 6 zeigt ein Diagramm mit der Abhängigkeit der internen Quanteneffizienz des Halbleiterchips von der Betriebsstromdichte für einen Halbleiterchip mit einer Löcher-Barriereschicht und einen Halbleiterchip ohne Löcherbarriereschicht und

Figur 7 zeigt eine schematische Schnittansicht eines zweiten Ausführungsbeispiels eines erfindungsgemäßen strahlungsemittierenden Halbleiterchips.

Gleiche, gleichartige und gleich wirkende Elemente sind in den Figuren mit gleichen Bezugszeichen versehen.

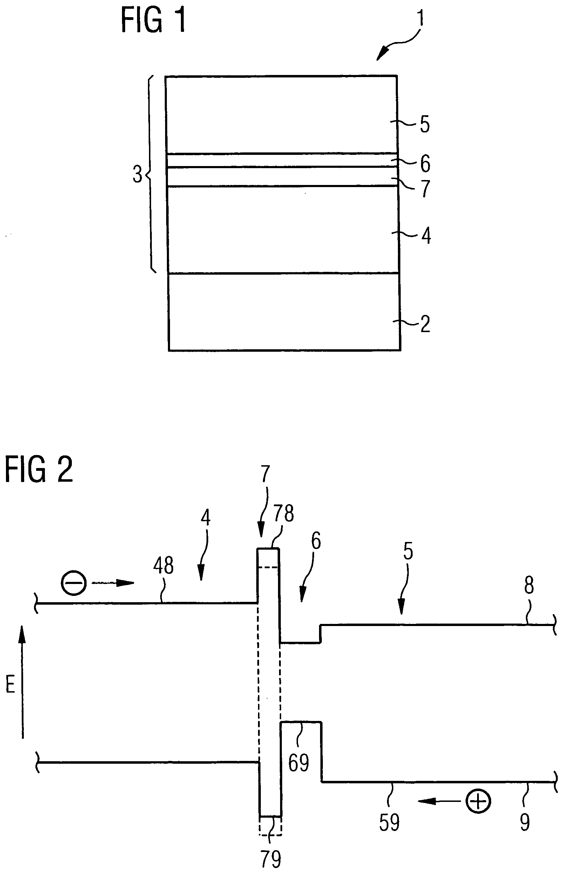

Figur 1 zeigt eine schematische Schnittansicht eines ersten Ausführungsbeispiels eines erfindungsgemäßen strahlungsemittierenden Halbleiterchips.

Der Halbleiterchip 1, der bevorzugt als LED-Chip ausgeführt ist, umfasst einen auf einem Träger 2 angeordneten Halbleiterkörper 3. Der Halbleiterkörper weist einen n-leitenden Bereich 4 und einen p-leitenden Bereich 5 auf, zwischen denen ein zur Strahlungserzeugung geeigneter aktiver Bereich 6 angeordnet ist. Der n-leitende und/oder der p-leitende Bereich kann eine Mehrzahl von Halbleiterschichten (nicht dargestellt) aufweisen. Zwischen dem n-leitenden Bereich 4 und dem aktiven Bereich 6 oder im n-leitenden Bereich integriert ist eine Löcher-Barriereschicht 7 ausgebildet. Vorzugsweise grenzt die Löcher-Barriereschicht 7 an den aktiven Bereich 6 an oder begrenzt diesen. Die Löcher-Barriereschicht 7 basiert auf einem Nitrid-Verbindungshalbleitermaterial aus dem Materialsystem $In_yGa_{1-x-y}Al_xN$ mit $0 \leq x \leq 1$, $0 \leq y \leq 1$ und $x + y \leq 1$ und ist derart ausgebildet, dass sie ein Eindringen von Löchern, die im Betrieb des Halbleiterchips 1 über den p-leitenden Bereich 5 in die aktive Zone geführt werden, mindert oder vollständig blockiert. Für Elektronen, die über den n-leitenden Bereich 4 zum aktiven Bereich 6 geführt werden, ist die Löcher-Barriereschicht 7 durchlässig ausgeführt. Elektronen-Loch-Paare können im aktiven Bereich unter Strahlungserzeugung rekombinieren.

Der Halbleiterkörper 3 ist bevorzugt epitaktisch auf einem Epitaxiesubstrat gewachsen. Der Träger 2 kann insbesondere aus dem Epitaxiesubstrat hervorgehen, auf dem eine Halbleiterschichtenfolge für den Halbleiterkörper gewachsen ist. Der Halbleiterkörper basiert weiterhin bevorzugt auf Nitrid-Verbindungshalbleitermaterialien. Ein SiC-Substrat oder ein Saphir-Substrat ist hierbei als Epitaxiesubstrat besonders geeignet.

Bevorzugt ist der Halbleiterchip zur Erzeugung ultravioletter oder sichtbarer Strahlung, insbesondere vom blauen bis in den grünen Spektralbereich ausgebildet. Zur Erzeugung von Strahlung in den genannten Spektralbereichen sind Nitrid-Verbindungshalbleiter besonders geeignet.

Der aktive Bereich 6 ist zweckmäßigerweise derart ausgebildet, dass sowohl für die Elektronen im Leitungsband als auch für die Löcher im Valenzband um den aktiven Bereich 6 herum beidseitige Barrieren ausgebildet sind, die Ladungsträger im aktiven Bereich einschließen. Die interne Quanteneffizienz des Halbleiterchips kann so erhöht werden. Bevorzugt wird eine dieser Barrieren durch die Löcher-Barriereschicht gebildet, die demnach auch als Einschlussschicht ausgebildet sein kann.

In einer bevorzugten Ausgestaltung umfasst der aktive Bereich 6 eine Ein- oder Mehrfachquantentopfstruktur. Derartige Strukturen sind für die Ausbildung eines aktiven Bereichs hoher interner Quanteneffizienz besonders geeignet.

Die Bezeichnung Quantentopfstruktur umfasst im Rahmen der Anmeldung jegliche Struktur, bei der Ladungsträger durch Einschluss ("confinement") eine Quantisierung ihrer Energiezustände erfahren. Insbesondere beinhaltet die Bezeichnung Quantentopfstruktur keine Angabe über die Dimensionalität der Quantisierung. Sie umfasst somit u. a. Quantentröge, Quantendrähte und Quantenpunkte und jede Kombination dieser Strukturen.

Mittels der Löcher-Barriereschicht 7 ist bevorzugt eine Potenzial-Barriere für die Löcher gebildet, über die das Eindringen von Löcher in den n-leitenden Bereich behindert wird. Die Wahrscheinlichkeit einer nichtstrahlenden Rekombination von Elektronen und Löchern außerhalb des aktiven Bereichs im n-leitenden Bereich kann so verringert werden. Hierdurch kann auch bei hohen Stromdichten die interne Quanteneffizienz des Halbleiterchips stabilisiert werden. Bei Verzicht auf die Löcher-Barriereschicht würde mit wachsender Stromdichte die Wahrscheinlichkeit des Eindringens von Löchern, die über den p-leitenden Bereich zum aktiven Bereich geführt wurden, in den n-leitenden Bereich 4 steigen. Die interne Quanteneffizienz würde dann entsprechend gemindert.

Aufgrund der im Halbleiterkörper 3 integrierten Löcher-Barriereschicht 7 ist also die von Löchern zu überwindenden Potenzial-Barriere für einen Eintritt in den n-leitenden Bereich 4 gegenüber einem Halbleiterkörper ohne Löcher-Barriereschicht mit Vorzug erhöht.

Die Barrierenhöhe kann mittels der Bandlücke der Löcher-Barriereschicht 7 und/oder über geeignete Dotierung der Löcher-Barriereschicht beeinflusst werden. Die Bandlücke z.B. kann über den Aluminiumgehalt x der Löcher-Barriereschicht eingestellt werden, wobei mit steigendem Aluminiumgehalt auch die Bandlücke wächst. Ein Aluminiumgehalt x von 0,2 oder mehr ist für eine Löcher-Barriereschicht 7 gemäß einer Ausführungsform der vorliegenden Erfindung besonders geeignet.

Um aufgrund der sich mit steigendem Aluminiumgehalt verringernden Gitterkonstante der Löcher-Barriereschicht entstehenden tensilen Verspannungen, die, insbesondere bei einer Löcher-Barriereschicht mit y = 0, mit steigendem Aluminiumgehalt vermehrt auftreten würden, im aktiven Bereich 6, der zum Beispiel auf $In_yGa_{1-y}N$ mit $0 < y \leq 1$ basiert, entgegen zu wirken, wird der Indiumgehalt y der Löcher-Barriereschicht 7 vorzugsweise größer 0 gewählt. Enthält die Löcher-Barriereschicht 7 sowohl Indium als auch Aluminium und gegebenenfalls Gallium, so gilt bevorzugt y < x. Zur Anpassung der Gitterkonstante beziehungsweise der Kompensation der durch das Aluminium induzierten Verspannung ist, insbesondere für einen aktiven Bereich, der auf $In_yGa_{1-y}N$ basiert, ein Indiumanteil y, der geringer als der Aluminiumanteil x ist, besonders geeignet. Die Löcher-Barriereschicht kann demnach zugleich als Pufferschicht für den aktiven Bereich 6 und als Barriereschicht für Löcher ausgeführt sein. Weiterhin ist der Aluminiumgehalt bevorzugt, insbesondere für eine indiumfreie Löcher-Barriereschicht, kleiner oder gleich 0,45. Verspannungen können so gering gehalten werden.

In einer bevorzugten Ausgestaltung ist die Löcher-Barriereschicht 7 als Tunnel-Barriereschicht ausgeführt. Ein Beispiel für ein Bänderdiagramm für eine Tunnel-Barriereschicht ist in Figur 2 schematisch dargestellt. Figur 2 zeigt schematisch den Verlauf der Leitungsbandkante 8 und der Valenzbandkante 9 im Halbleiterkörper 3 des Halbleiterchips, der bevorzugt in Durchlassrichtung betrieben ist.

Die Leitungsbandkante 78 der als Tunnel-Barriereschicht ausgebildeten Löcher-Barriereschicht 7 liegt energetisch oberhalb der Leitungsbandkante 48 der im n-leitenden Bereich 4 an die Löcher-Barriereschicht 7 angrenzenden Schicht. Die Valenzbandkante 79 der Tunnel-Barriereschicht liegt energetisch unterhalb der Valenzbandkante 69 des aktiven Bereichs und bevorzugt unterhalb der Valenzbandkante 59 der seitens des p-leitenden Bereichs 5 an den aktiven Bereich 6 angrenzenden Schicht. Elektronen, die vom n-leitenden Bereich 4 zum aktiven Bereich 6 geführt werden, müssen ebenso wie Löcher für ein Eindringen in den n-leitenden Bereich eine Potenzial-Barriere überwinden. Die Höhe der zu überwindenden Potenzial-Barriere für Elektronen ist durch die Differenz der Energien der Leitungsbandkante 78 und der Leitungsbandkante 48, die Höhe der Potenzial-Barriere für die Löcher durch die Differenz der Energien der Valenzbandkante 69 und der Valenzbandkante 79 gegeben.

Die Tunnelwahrscheinlichkeit, mit der die Ladungsträger die Tunnel-Barriereschicht durchtunneln hängt von der jeweiligen zu überwindenden Barrierenhöhe und der Dicke der Tunnel-Barriereschicht ab. Näherungsweise (in WKB-Näherung) ist die Tunnelwahrscheinlichkeit T proportional zu

$$T \propto \exp\left(-\frac{2d}{\hbar} \cdot \sqrt{2m \cdot (V_0 - E)}\right)$$

mit der absoluten Barrierenhöhe $V_0$, der Barrierendicke d, sowie der Energie E der Ladungsträger und der effektiven Masse m der jeweiligen Ladungsträger. Die von den Ladungsträgern zu überwindende Barrierenhöhe ist durch die Differenz der absoluten Barrierenhöhe $V_0$ - der Energie der Leitungs- bzw. Valenzbandkante der Tunnel-Barriereschicht - und der Energie E der jeweiligen Ladungsträger bestimmt. Die Barrierenhöhe kann über die Bandlücke, das heißt die Differenz der Energien der Valenzbandkante und der Leitungsbandkante der Löcher-Barriereschicht 7, eingestellt werden. Wie oben bereits ausgeführt kann dies über den Aluminiumgehalt x erfolgen.

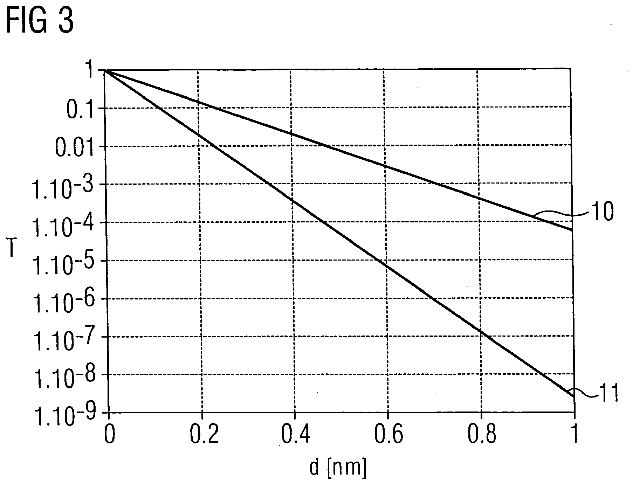

In Figur 3 ist die Abhängigkeit der Tunnelwahrscheinlichkeit 10 für Elektronen und der Tunnelwahrscheinlichkeit 11 für Löcher in Abhängigkeit von der Dicke d der Tunnel-Barriereschicht in Nanometern für eine

$Al_{0,5}Ga_{0,5}N$-Tunnel-Barriereschicht in einem Diagramm dargestellt. Die Tunnelwahrscheinlichkeiten wurden auf der Grundlage der oben angegebenen Beziehung ermittelt. Da die effektive Masse der Löcher größer ist als die der Elektronen, nimmt die Tunnelwahrscheinlichkeit 11 mit wachsender Dicke der Tunnel-Barriereschicht wesentlich stärker ab als die der Elektronen. Die effektive Masse der Löcher beträgt ungefähr das zehnfache oder mehr der effektiven Masse der Elektronen. Daraus ergeben sich verschiedene Tunnelwahrscheinlichkeiten für Elektronen und für Löcher, sodass über Ladungsträger-Asymmetrisches-Tunneln (Carrier Asymmetric Tunneling) Elektronen die Tunnel-Barriereschicht zu einem weit größeren Anteil durchtunneln können als Löcher. Löcher werden mittels der Tunnel-Barriereschicht größtenteils seitens des aktiven Bereichs 6 gehalten.

Die Tunnelwahrscheinlichkeit der Elektronen durch die Tunnel-Barriereschicht kann das zehnfache oder mehr, bevorzugt das hundertfache oder mehr, besonders bevorzugt das tausendfache oder mehr, der Tunnelwahrscheinlichkeit der Löcher durch die Tunnel-Barriereschicht betragen. Dies kann durch geeignete Ausbildung der Tunnel-Barriereschicht erreicht werden.

Bevorzugt beträgt die Dicke der Tunnel-Barriereschicht 8 nm oder weniger, besonders bevorzugt 4 nm oder weniger. Eine Dicke von größer oder gleich 1 nm hat sich als besonders vorteilhaft herausgestellt. Für den Aluminiumgehalt x eignen sich besonders Werte zwischen jeweils einschließlich 0,2 und 0,45, bevorzugt größer oder gleich 0,3. Insbesondere im Hinblick auf moderate Gitterfehlanpassung sind Tunnel-Barriereschichten mit derartigem Aluminiumgehalt besonders geeignet.

Das Verhältnis der Tunnelwahrscheinlichkeit der Elektronen zu derjenigen der Löcher kann gegebenenfalls noch gezielt herabgesetzt werden. Hierzu kann die Tunnel-Barriereschicht beispielsweise n-leitend dotiert werden. Die Leitungsbandkante 78 der Tunnel-Barriereschicht wird dann, ebenso wie die Valenzbandkante 79 der Tunnel-Barriereschicht abgesenkt. Die Bandlücke bleibt im wesentlichen konstant, sodass die Barrierenhöhe für Löcher vergrößert wird, während die Barrierenhöhe für Elektronen verringert wird. Ein Dotierstoff mit vergleichsweise tiefen Donatorniveaus, zum Beispiel Si, ist hierfür besonders geeignet.

Alternativ oder zusätzlich können gezielt Störstellen in die Tunnel-Barriereschicht eingebaut sein, die das Tunneln der Elektronen gegenüber dem Löchertunneln assistieren (trap assisted tunneling) und demgemäß die Tunnelwahrscheinlichkeit für Elektronen gegenüber derjenigen der Löcher erhöhen. Für ein Störstellenatom eignet sich beispielsweise Si.

Eine gezielte Herabsetzung der Potenzial-Barriere für die Elektronen ist in Figur 2 gestrichelt angedeutet. Mittels der Tunnel-Barriereschicht kann mit Vorteil die Stromdichteabhängigkeit der internen Quanteneffizienz reduziert werden, da die Löcher, auch bei hohen Stromdichten, vermehrt strahlend im aktiven Bereich 6 rekombinieren und das Eindringen von Löchern in den n-leitenden Bereich mittels der Tunnel-Barriereschicht effektiv blockiert wird.

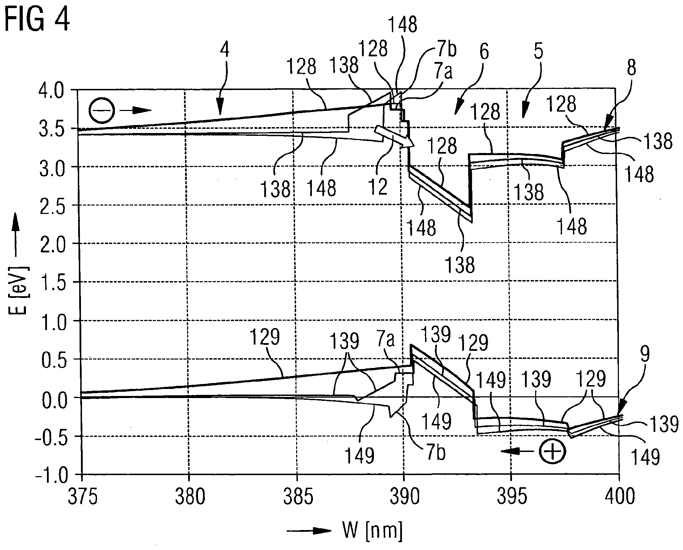

Figur 4 zeigt anhand von in einer Simulationsrechnung ermittelten Bänderdiagrammen den Einfluss des Aluminiumgehalts auf die Barrierenhöhe einer $Al_xGa_{1-x}N$-Tunnel-Barriereschicht mit x > 0. Aufgetragen sind die Valenz- und Leitungsbandkanten in einem Halbleiterkörpers ähnlich dem in Figur 1 gezeigten für Löcher-Barriereschichten mit verschiedenen Aluminiumgehalten. Die W-Richtung gibt die Wachstumsrichtung des Halbleiterkörpers an, in der die einzelnen Schichten für den Halbleiterkörper, z.B. epitaktisch auf einem Epitaxiesubstrat, nacheinander gewachsen wurden.

Die Leitungsbandkante 128 und die Valenzbandkante 129 entsprechen einem Halbleiterkörper auf Nitrid-Verbindungshalbleiter-Basis ohne aluminiumhaltige Tunnel-Barriereschicht. Der Halbleiterchip mit dem Halbleiterkörper wurde als mit 3,4 Volt in Durchlassrichtung betrieben angenommen.

Bei der Leitungsbandkante 138 und der Valenzbandkante 139 ist eine Tunnel-Barriereschicht 7a mit x = 0,15 vorgesehen. Für die Leitungsbandkante 148 und die Valenzbandkante 149 weist die Tunnel-Barriereschicht 7b einen Aluminiumgehalt von 0,3 auf. Die Barrierenhöhe der Potenzial-Barriere der Tunnel-Barriereschicht wächst für Elektronen wie auch für Löcher mit der sich aufgrund des wachsenden Aluminiumgehalts vergrößernden Bandlücke der Tunnel-Barriereschicht. Der Pfeil 12 symbolisiert ein Tunneln der Elektronen in den aktiven Bereich.

Gemäß einer Ausführungsform der vorliegenden Erfindung ist die Löcher-Barriereschicht 7 als reine Löcher-Barriereschicht ausgeführt. Elektronen gelangen bei einer reinen Löcher-Barriereschicht, im Gegensatz zu einer Tunnel-Barriereschicht, im wesentlichen ungehindert, das heißt potenzialbarrierefrei, aus dem n-leitenden Bereich 4 in den aktiven Bereich 6.

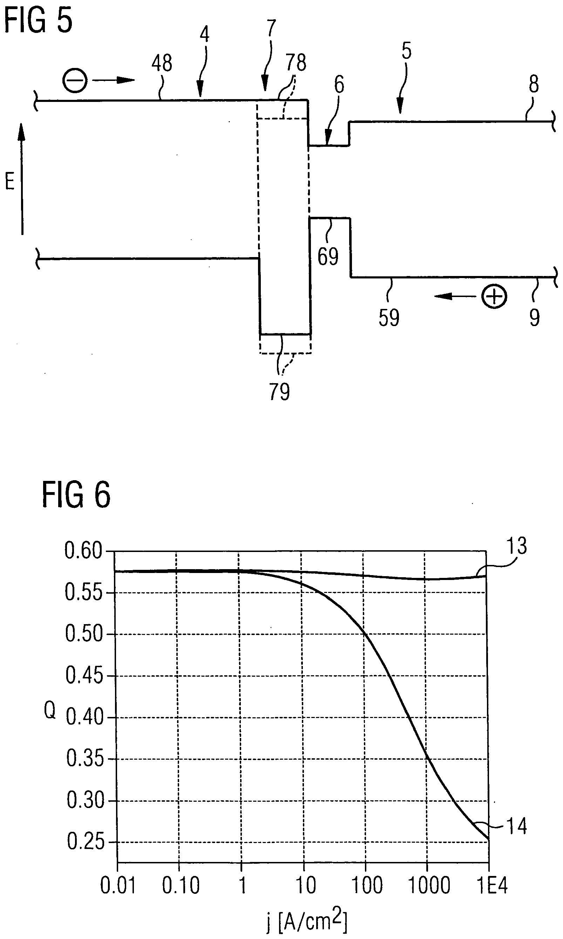

Figur 5 zeigt schematisch ein Bänderdiagramm für eine reine Löcher-Barriereschicht. Im wesentlichen entspricht Figur 5 dem in Figur 2 gezeigten Diagramm. Im Unterschied hierzu weist die Löcher-Barriereschicht 7 eine Leitungsbandkante 78 auf, deren Energie kleiner oder gleich derjenigen der Leitungsbandkante 48 einer seitens des n-leitenden Bereichs 4 an die reine Löcher-Barriereschicht 7 angrenzenden Schicht ist. Die Valenzbandkante 79 der reinen Löcher-Barriereschicht liegt energetisch tiefer als die Valenzbandkante 69 der seitens des aktiven Bereichs angrenzenden Schicht und vorzugsweise energetisch tiefer als die Valenzbandkante 59 einer seitens des p-leitenden Bereichs 5 an den aktiven Bereich 6 angrenzenden Schicht. Elektronen können so im Halbleiterkörper im wesentlichen potenzialbarrierefrei vom n-leitenden Bereich 4 in den aktiven Bereich 6 eintreten, während die Potenzial-Barriere von den Löchern zu überwinden ist, um in den n-leitenden Bereich 4 zu gelangen. Im Unterschied zu einer Tunnel-Barriereschicht kann die reine Löcher-Barriereschicht vergleichsweise dick ausgeführt sein, da ein Durchtunneln von Elektronen nicht berücksichtigt werden muss. Die Durchtrittswahrscheinlichkeit von Löchern in den n-leitenden Bereich kann so äußerst gering gehalten werden, beispielsweise kleiner oder gleich als $10^{-4}$ oder kleiner oder gleich $10^{-5}$. Beispielsweise weist die reine Löcher-Barriereschicht einen Aluminiumgehalt zwischen einschließlich 0,2 und einschließlich 0,3 auf. Eine Dicke der reinen Löcher-Barriereschicht kann zwischen einschließlich 11 nm und 30 nm betragen. Gegebenenfalls kann die reine Löcher-Barriereschicht auch dicker ausgeführt werden. Weiterhin ist die reine Löcher-Barriereschicht bevorzugt stärker dotiert ($n^+$) als eine seitens des n-leitenden Bereiches angeordnete, insbesondere an die Löcher-Barriereschicht angrenzende, Schicht. Das Ausbilden eines für Elektronen barrierefreien Übergangs zum aktiven Bereich kann so erleichtert werden. Weiterhin kann die Leitungsbandkante 78 der Löcher-Barriereschicht auch energetisch unterhalb der Leitungsbandkante 48 liegen. Dies ist in Figur 5 gestrichelt angedeutet.

Insgesamt kann mit den oben beschriebenen Löcher-Barriereschichten - einer reinen Löcher-Barriereschicht oder einer Tunnel-Barriereschicht - die Stromdichteabhängigkeit der internen Quanteneffizienz des Halbleiterchips 1 vereinfacht verringert werden.

Dies wird durch das Diagramm in Figur 6, welches die Ergebnisse einer Simulation zeigt, verdeutlicht. In Figur 6 ist die Abhängigkeit der internen Quanteneffizienz Q in Prozent des Halbleiterchips 1 von der Betriebsstromdicht j in Ampere pro Quadratzentimeter gezeigt. Die Stromdichte j ist logarithmisch aufgetragen. Die Kurve 14 wurde für einen Halbleiterchip mit einem Halbleiterkörper auf Nitrid-Verbindungshalbleiterbasis ohne aluminiumhaltige Löcher-Barriereschicht und die Kurve 13 für einen entsprechenden Halbleiterkörper mit aluminiumhaltiger Löcher-Barriereschicht ermittelt. Die Abhängigkeit der internen Quanteneffizienz Q von der Stromdichte j ist bei der Kurve 13 gegenüber der Kurve 14 stark verringert. Die interne Quanteneffizienz ist für den Halbleiterchip mit der Löcher-Barriereschicht im wesentlichen konstant und unabhängig von der Betriebsstromdichte.

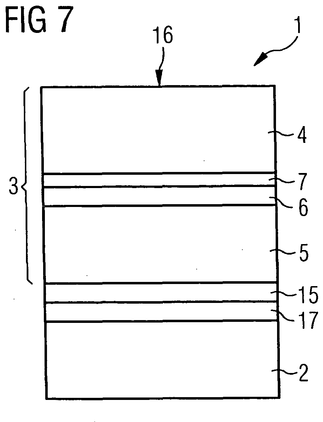

Figur 7 zeigt eine schematische Schnittansicht eines zweiten Ausführungsbeispiels eines erfindungsgemäßen Halbleiterchips 1.

Im wesentlichen entspricht der Halbleiterchip 1 dem in Zusammenhang mit Figur 1 beschriebenen Halbleiterchip. Im Unterschied hierzu ist der in Figur 7 gezeigte Halbleiterchip 1 als Dünnfilm-Chip ausgeführt. Demnach ist der Träger 2 von einem Epitaxiesubstrat, auf dem eine Halbleiterschichtenfolge für den Halbleiterkörper 3 epitaktisch gewachsen ist, verschieden. Der Halbleiterkörper 3 kann auf dem Epitaxiesubstrat gefertigt sein und nachfolgend mit seiner, dem Epitaxiesubstrat abgewandten Seite auf dem Träger 2 angeordnet und vorzugsweise befestigt werden. Mit Vorteil muss der Träger 2 nicht den strengen Anforderungen an ein Epitaxiesubstrat genügen. Nachfolgend kann das Epitaxiesubstrat entfernt werden, sodass der Dünnfilm-Chip frei von einem Epitaxiesubstrat ist. Hierzu eignet sich beispielsweise Ätzen, Wasserstrahlschneiden oder ein Lasertrennverfahren. Für einen Halbleiterkörper auf Nitrid-Verbindungshalbleiterbasis eignet sich beispielsweise SiC oder Saphir als Material für das Epitaxiesubstrat. Gegebenenfalls kann auch der Träger derartige Materialien enthalten. Alternativ kann der Träger metallisch oder als Keramik ausgeführt sein. Hierdurch kann die elektrische Leitfähigkeit oder die Wärmeleitfähigkeit gegenüber einem Epitaxiesubstrat weitergehend verbessert sein.

Bevorzugt ist zwischen dem Träger 2 und dem Halbleiterkörper 3 eine, insbesondere metallische, Spiegelschicht 15, angeordnet. Diese kann einer Absorption im aktiven Bereich 6 erzeugter Strahlung in einem eventuell absorbierenden Träger über Reflexion der Strahlung an der Spiegelschicht vorbeugen. Weiterhin kann der über die dem Träger abgewandte Hauptfläche 16 aus dem Halbleiterkörper 3 austretende Strahlungsanteil aufgrund der Spiegelschicht erhöht sein. Zwischen der Spiegelschicht 15 und dem Träger 2 ist bevorzugt eine Verbindungsschicht 17 angeordnet, mittels derer der Halbleiterkörper 3 auf dem Träger 2 befestigt ist. Die Verbindungsschicht 17 kann beispielsweise als Lotschicht oder eine in einem Waferbondingverfahren ausgebildete Schicht ausgeführt sein. Bevorzugt ist die Verbindungsschicht 17, die Spiegelschicht 15 und/oder der Träger 2 elektrisch leitend ausgeführt. Besonders bevorzugt ist die Verbindungsschicht 17, die Spiegelschicht 15 und/oder der Träger 2 mit dem aktiven Bereich 6 elektrisch leitend verbunden. Der aktive Bereich 6 kann so mittels einer auf der dem Halbleiterkörper abgewandten Seite des Trägers angeordneten Kontaktschicht (nicht dargestellt) elektrisch kontaktiert werden. Eine entsprechende Gegenkontaktschicht (nicht dargestellt) kann auf der Hauptfläche 16 angeordnet sein. Diese Kontaktschicht(en) ist (sind) vorzugsweise metallisch ausgeführt.

Für einen auf Nitrid-Verbindungshalbleitern, die zur Strahlungserzeugung vom ultravioletten bis in den grünen Spektralbereich, besonders geeignet sind, basierenden aktiven Bereich enthält die Spiegelschicht 15 bevorzugt Al, Ag, Pt oder eine Legierung mit mindestens einem dieser Materialien. Diese Materialien können in den genannten Spektralbereichen vorteilhaft hohe Reflektivitäten aufweisen.

Die Löcher-Barriereschicht 7 ist bei dem Dünnfilm-Chip auf der dem Träger 2 abgewandten Seite des aktiven Bereichs 6 angeordnet, da der Halbleiterkörper nach Abschluss des Wachstums mit dem p-leitenden Bereich 5 auf dem Träger 2 angeordnet wurde. Die Löcher-Barriereschicht kann entsprechend den obigen Ausführungen ausgebildet sein, wobei die Effizienz, insbesondere die Auskoppeleffizienz, des Halbleiterchips aufgrund der Spiegelschicht und der vergleichsweise freien Wahl des Trägers vorteilhaft erhöht sein kann.

Insbesondere kann eine erfindungsgemäße Löcher-Barriereschicht nicht nur bei LED-Chips, sondern auch bei Laserchips mit optischem Resonator, wie einem kantenemittierendem Laserchip, einem VCSEL (Vertical Cacity Surface Emitting Laser) mit internem Resonator, einem VECSEL (Vertical External Cacity Surface Emitting Laser) mit externem Resonator oder einer RCLED (Resonant Cavity Light Emitting Diode) eingesetzt werden.

**Patentansprüche**

1. Strahlungsemittierender Halbleiterchip (1) umfassend einen Halbleiterkörper (3), der einen n-leitenden Bereich (4) und einen p-leitenden Bereich (5) aufweist, wobei

   - zwischen dem n-leitenden Bereich und dem p-leitenden Bereich ein zur Strahlungserzeugung geeigneter aktiver Bereich (6) angeordnet ist, in dem über den n-leitenden Bereich in den aktiven Bereich geführte Elektronen und über den p-leitenden Bereich in den aktiven Bereich geführte Löcher unter Strahlungserzeugung rekombinieren,
   - auf der dem p-leitenden Bereich gegenüberliegenden Seite des aktiven Bereichs eine Löcher-Barriereschicht (7) angeordnet ist, die ein Material aus dem III-V-Halbleitermaterialsystem $In_yGa_{1-x-y}Al_xN$ mit $0 \leq x \leq 1$, $0 \leq y \leq 1$ und $x + y \leq 1$, enthält, und derart ausgebildet ist, dass sie ein Eindringen von Löchern in den n-leitenden Bereich (4) mindert oder vollständig blockiert,
   - die Löcher-Barriereschicht eine Dicke zwischen einschließlich 11 nm und 30 nm oder mehr als 30 nm aufweist,

   **dadurch gekennzeichnet, dass**

   i. die Löcher-Barriereschicht (7) als reine Löcher-Barriereschicht ausgebildet ist, bei der die Energie der Leitungsbandkante (78) der Löcher-Barriereschicht kleiner oder gleich der Energie der Leitungsbandkante (48) einer seitens des n-leitenden Bereiches (4) angeordneten an die Löcher-Barriereschicht (7) angrenzenden Schicht ist, sodass Elektronen aus dem n-leitenden Bereich potenzialbarrierefrei durch die reine Löcher-Barriereschicht in den aktiven Bereich gelangen können, wobei zur Ausbildung der reinen Löcher-Barriereschicht (7) die Löcher-Barriereschicht (7) stärker n-dotiert ist als die seitens des n-leitenden Bereichs (4) angeordnete an die Löcher-Barriereschicht angrenzende Schicht, oder

   ii. die Löcher-Barriereschicht (7) das Material aus dem III-V-Halbleitermaterialsystem $In_yGa_{1-x-y}Al_xN$ mit $0,2 \leq x \leq 1$; $0 < y < x$ und $x + y \leq 1$ enthält, wobei die Bandlücke der indiumhaltigen und aluminiumhaltigen Löcher-Barriereschicht (7) und somit eine resultierende Potenzialbarriere für die Löcher mittels Variation des Aluminiumgehalts eingestellt sind, und Gitterkonstante der Löcher-Barriereschicht (7) über Variation des Indiumgehalts y derart eingestellt ist, dass die Löcher-Barriereschicht (7) zur Reduzierung von tensilen Verspannungen im Halbleiterkörper (3) gleichzeitig als Pufferschicht für Schichten des aktiven Bereichs (6) ausgebildet ist.

2. Halbleiterchip nach Anspruch 1,
**dadurch gekennzeichnet, dass**
die Löcher-Barriereschicht (7) zwischen dem n-leitenden Bereich (4) und dem aktiven Bereich (6) angeordnet ist oder die Löcher-Barriereschicht auf einer dem aktiven Bereich zugewandten Seite des n-leitenden Bereichs im n-leitenden Bereich integriert ist.

3. Halbleiterchip nach Anspruch 1 oder 2,
**dadurch gekennzeichnet, dass**
die Löcher-Barriereschicht (7) an den aktiven Bereich (6) angrenzt oder die Löcher-Barriereschicht den aktiven Bereich begrenzt.

4. Halbleiterchip nach mindestens einem der vorhergehenden Ansprüche, wobei der n-leitende Bereich (4) durch die Löcher-Barriereschicht (7) seitens des aktiven Bereichs (6) begrenzt ist.

5. Halbleiterchip nach mindestens einem der vorhergehenden Ansprüche, wobei der Al-Anteil x zwischen einschließlich 0,2 und 0,45 ist.

6. Halbleiterchip nach Anspruch 1,
**dadurch gekennzeichnet, dass**
$x \leq 0,45$ ist.

7. Halbleiterchip nach mindestens einem der vorhergehenden Ansprüche,
**dadurch gekennzeichnet, dass**
der aktive Bereich (6) auf dem Materialsystem $In_yGa_{1-y}N$ mit $0 < y \leq 1$ basiert.

8. Halbleiterchip nach mindestens einem der Ansprüche 1 bis 7,
**dadurch gekennzeichnet, dass**
die Löcher-Barriereschicht (7) ein Durchtreten von Löchern blockiert.

9. Halbleiterchip nach einem der Ansprüche 1 bis 8,
**dadurch gekennzeichnet, dass**
die reine Löcher-Barriereschicht für die Elektronen vollständig durchlässig ist.

10. Halbleiterchip nach einem der Ansprüche 1 bis 9,
**dadurch gekennzeichnet, dass**

die Valenzbandkante (79) der reinen Löcher-Barriereschicht energetisch tiefer als die Valenzbandkante (69) der seitens des aktiven Bereichs angrenzenden Schicht und energetisch tiefer als die Valenzbandkante (59) einer seitens des p-leitenden Bereichs (5) an den aktiven Bereich (6) angrenzenden Schicht liegt.

11. Halbleiterchip nach mindestens einem der vorhergehenden Ansprüche,
**dadurch gekennzeichnet, dass**
der Halbleiterchip (1) als Dünnfilm-Chip ausgeführt ist.

12. Halbleiterchip nach mindestens einem der vorhergehenden Ansprüche,
**dadurch gekennzeichnet, dass**
der Halbleiterkörper (3) auf einem Träger (2) angeordnet ist.

13. Halbleiterchip nach Anspruch 12,
**dadurch gekennzeichnet, dass**
zwischen dem aktiven Bereich (6) und dem Träger (2) eine Spiegelschicht (15) angeordnet ist.

14. Halbleiterchip nach Anspruch 13,
**dadurch gekennzeichnet, dass**
die Spiegelschicht metallisch ist.

15. Halbleiterchip nach Anspruch 14,
**dadurch gekennzeichnet, dass**
die Spiegelschicht elektrisch leitend ausgeführt ist.

**Claims**

1. A radiation-emitting semiconductor chip (1) comprising a semiconductor body (3), which has an n-conducting region (4) and a p-conducting region (5), wherein

- between the n-conducting region and the p-conducting region an active region (6) suitable for generating radiation is arranged, in which electrons passed into the active region via the n-conducting region and holes passed into the active region via the p-conducting region recombine with generation of radiation,
- on a side of the active region opposite to the p-conducting region a hole barrier layer (7) is arranged which contains a material from the III-V semiconductor material system $In_yGa_{1-x-y}Al_xN$ with $0 \leq x \leq 1$, $0 \leq y \leq 1$ and $x + y \leq 1$, and is configured in such a way for reducing or completely blocking a penetration of holes into the n-conducting region (4),
- the hole barrier layer has a thickness between 11 nm and 30 nm inclusive or greater than 30 nm,

**characterized in that**

i. the hole barrier layer (7) is formed as a pure hole barrier layer, in which the energy of the conduction band edge (78) of the hole barrier layer is less than or equal to the energy of the conduction band edge (48) of a layer arranged on the side of the n-conducting region (4) adjacent to the hole barrier layer (7), so that electrons from the n-conducting region can pass in a manner free of a potential barrier through the pure hole barrier layer into the active region, wherein in order to form the pure hole barrier layer (7) the hole barrier layer (7) is n-doped stronger than the layer adjacent to the hole barrier layer arranged on the side of the n-conducting region (4), or

ii. the hole barrier layer (7) contains the material from the III-V semiconductor material system $In_yGa_{1-x-y}Al_xN$ with $0,2 \leq x \leq 1$, $0 < y < x$ and $x + y \leq 1$, wherein the band gap of the indium-containing and aluminum-containing hole barrier layer (7) and thus a resulting potential barrier for the holes are set by variation of the aluminum content, and lattice constant of the hole barrier layer (7) is set by variation of the indium content y in such a way that the hole barrier layer (7) is formed simultaneously as a buffer layer for layers of the active region (6) in order to reduce tensil stresses in the semiconductor body (3).

2. The semiconductor chip according to claim 1,
**characterized in that**
the hole barrier layer (7) is arranged between the n-conducting region (4) and the active region (6) or the hole barrier layer is integrated in the n-conducting region on a side of the n-conducting region that faces the active region.

3. The semiconductor chip according to claim 1 or 2,
**characterized in that**
the hole barrier layer (7) adjoins the active region (6) or the hole barrier layer delimits the active region.

4. The semiconductor chip according to at least one of the preceding claims,
wherein the n-conducting region (4) is delimited by the hole barrier layer (7) on the side of the active region (6).

5. The semiconductor chip according to at least one of the preceding claims,
wherein the Al portion x is between 0.2 and 0.45 inclusive.

6. The semiconductor chip according to claim 1,

**characterized in that** x is $\leq 0.45$.

7. The semiconductor chip according to at least one of the preceding claims,
**characterized in that**
the active region (6) is based on the material system $In_yGa_{1-y}N$ with $0 < y \leq 1$.

8. The semiconductor chip according to at least one of claims 1 to 7,
**characterized in that**
the hole barrier layer (7) blocks the passage of holes.

9. The semiconductor chip according to any of claims 1 to 8,
**characterized in that**
the pure hole barrier layer is completely transmissive to electrons.

10. The semiconductor chip according to any of claims 1 to 9,
**characterized in that**
the valence band edge (79) of the pure hole barrier layer is energetically lower than the valence band edge (69) of the adjacent layer on the side of the active region and energetically lower than the valence band edge (59) of a layer adjacent to the active region (6) on the side of the p-conducting region (5).

11. The semiconductor chip according to at least one of the preceding claims,
**characterized in that**
the semiconductor chip (1) is formed as a thin-film chip.

12. The semiconductor chip according to at least one of the preceding claims,
**characterized in that**
the semiconductor body (3) is arranged on a carrier (2).

13. The semiconductor chip according to claim 12,
**characterized in that**
a mirror layer (15) is arranged between the active region (6) and the support (2).

14. The semiconductor chip according to claim 13,
**characterized in that**
the mirror layer is metallic.

15. The semiconductor chip according to claim 14,
**characterized in that**
the mirror layer is electrically conductive.

**Revendications**

1. Puce électronique à semiconducteur émettant une radiation (1), comportant un corps de semiconducteur (3) qui présente une zone à conduction type n (4) et une zone à conduction type p (5), sachant que

- entre la zone à conduction type n et la zone à conduction type p est disposée une zone active (6) adéquate pour la génération de rayonnement, dans laquelle des électrons guidés via la zone à conduction type n dans la zone active et des trous guidés via la zone à conduction type p dans la zone active se recombinent sous génération de rayonnement,
- sur le côté de la zone active se trouvant face à la zone à conduction type p est disposée une couche à trous formant barrière (7) qui contient un matériau provenant du système de matériaux semiconducteurs III-V $In_yGa_{1-x-y}Al_xN$ avec $0 \leq x \leq 1$, $0 \leq y \leq 1$ et $x + y \leq 1$, et est constituée de sorte qu'elle réduit ou bloque complètement une pénétration des trous dans la zone à conduction type n (4),
- la couche à trous formant barrière présente une épaisseur comprise entre 11 nm inclus et 30 nm ou de plus de 30 nm, **caractérisée en ce que**

i. la couche à trous formant barrière (7) est constituée comme pure couche à trous formant barrière, pour laquelle l'énergie du bord de bande de conduction (78) de la couche à trous formant barrière est inférieure ou égale à l'énergie du bord de bande de conduction (48) d'une couche adjacente disposée du côté de la zone à conduction type n (4) sur la couche à trous formant barrière (7), de sorte que des électrons peuvent parvenir sans barrière de potentiel à partir de la zone à conduction type n à travers la pure couche à trous formant barrière dans la zone active, sachant qu'en vue de la formation de la pure couche à trous formant barrière (7) la couche à trous formant barrière (7) est dopée plus fortement à conduction type n que la couche adjacente à la couche formant barrière disposée du côté de la zone à conduction type n (4), ou
ii. la couche à trous formant barrière (7) contient le matériau provenant du système de matériaux semiconducteurs III-V $In_yGa_{1-x-y}Al_xN$ avec $0,2 \leq x \leq 1$; $0 < y < x$ et $x + y \leq 1$, sachant que la bande interdite de la couche à trous formant barrière (7) contenant de l'indium et contenant de l'aluminium et par conséquent une barrière de potentiel résultante sont réglées pour les trous au moyen d'une variation du taux d'aluminium, et une constante de réseau de la couche à trous formant barrière (7) est réglée via une variation du taux d'indium y, de sorte que la couche à trous formant barrière (7) en vue de la réduction des tensions d'élasticité dans le corps de semiconducteur (3), est constituée en même temps comme couche tampon pour des couches de la zone active (6).

2. Puce électronique à semiconducteur selon la revendication 1,
   **caractérisée en ce que**
   la couche à trous formant barrière (7) est disposée entre la zone à conduction type n (4) et la zone active (6) ou la couche à trous formant barrière est intégrée dans la zone à conduction type n sur un côté tourné vers la zone active de la zone à conduction type n.

3. Puce électronique à semiconducteur selon les revendications 1 ou 2,
   **caractérisée en ce que**
   la couche à trous formant barrière (7) est adjacente à la zone active (6) ou la couche à trous formant barrière limite à la zone active.

4. Puce électronique à semiconducteur selon au moins une quelconque des revendications précédentes, sachant que la zone à conduction type n (4) est limitée par la couche à trous formant barrière (7) du côté de la zone active (6).

5. Puce électronique à semiconducteur selon au moins une quelconque des revendications précédentes, sachant que la part d'Al x est entre 0,2 et 0,45, les deux valeurs incluses.

6. Puce électronique à semiconducteur selon la revendication 1,
   **caractérisée en ce que**
   x est $\leq 0,45$.

7. Puce électronique à semiconducteur selon au moins une quelconque des revendications précédentes,
   **caractérisée en ce que**
   la zone active (6) se base sur le système de matériaux $In_yGa_{1-y}N$ avec $0 < y \leq 1$.

8. Puce électronique à semiconducteur selon au moins une quelconque des revendications 1 à 7,
   **caractérisée en ce que**
   la couche à trous formant barrière (7) bloque un passage dans les trous.

9. Puce électronique à semiconducteur selon une quelconque des revendications 1 à 8,
   **caractérisée en ce que**
   la pure couche à trous formant barrière est entièrement perméable aux électrons.

**10.** Puce électronique à semiconducteur selon une quelconque des revendications 1 à 9,
**caractérisée en ce que**
le bord de bande de valence (79) de la pure couche à trous formant barrière étant énergétiquement plus bas que le bord de bande de valence (69) de la couche adjacente du côté de la zone active et énergétiquement plus bas que le bord de bande de valence (59) d'une couche adjacente à la zone active (6) du côté de la zone à conduction type p (5).

**11.** Puce électronique à semiconducteur selon au moins une quelconque des revendications précédentes,
**caractérisée en ce que**
la puce électronique à semiconducteur (1) est réalisée comme puce électronique à film fin.

**12.** Puce électronique à semiconducteur selon au moins une quelconque des revendications précédentes,
**caractérisée en ce que**
la puce électronique à semiconducteur (3) est disposée sur un support (2).

**13.** Puce électronique à semiconducteur selon la revendication 12,
**caractérisée en ce que**
entre la zone active (6) et le support (2), une couche miroir (15) est disposée.

**14.** Puce électronique à semiconducteur selon la revendication 13,
**caractérisée en ce que**
la couche miroir est métallique.

**15.** Puce électronique à semiconducteur selon la revendication 14,
**caractérisée en ce que**
la couche miroir est réalisée de manière électriquement conductrice.

## FIG 1

## FIG 2

# FIG 3

FIG 4

# FIG 5

# FIG 6

FIG 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20030001170 A1
- US 5889295 A
- JP H06209139 A
- US 5889806 A

**In der Beschreibung aufgeführte Nicht-Patentliteratur**

- **I. SCHNITZER et al.** *Appl. Phys. Lett.,* 18. Oktober 1993, vol. 63 (16), 2174-2176